(19) Europäisches Patentamt
European Patent Office
Office européen des brevets

(11) **EP 2 243 268 B1**

(12) **FASCICULE DE BREVET EUROPEEN**

(45) Date de publication et mention
de la délivrance du brevet:
**19.10.2011 Bulletin 2011/42**

(21) Numéro de dépôt: **09703466.4**

(22) Date de dépôt: **14.01.2009**

(51) Int Cl.:
*H04L 27/36* (2006.01)  *H03F 1/32* (2006.01)
*H03M 3/02* (2006.01)  *H04B 7/005* (2006.01)
*H04W 88/02* (2009.01)

(86) Numéro de dépôt international:
**PCT/FR2009/050046**

(87) Numéro de publication internationale:
**WO 2009/092959 (30.07.2009 Gazette 2009/31)**

(54) **SYSTEME D'EMISSION RADIOFREQUENCE**

FUNKFREQUENZENEMISSIONSSYSTEM

RADIOFREQUENCY EMISSION SYSTEM

(84) Etats contractants désignés:
**AT BE BG CH CY CZ DE DK EE ES FI FR GB GR
HR HU IE IS IT LI LT LU LV MC MK MT NL NO PL
PT RO SE SI SK TR**

(30) Priorité: **15.01.2008 FR 0850231**

(43) Date de publication de la demande:
**27.10.2010 Bulletin 2010/43**

(73) Titulaire: **Commissariat à l'Énergie Atomique
et aux Énergies Alternatives
75015 Paris (FR)**

(72) Inventeurs:
• **WURM, Patrick
décédé (FR)**
• **SHIRAKAWA, Alexandre
San Jose
California 95110 (US)**

(74) Mandataire: **Vuillermoz, Bruno et al
Cabinet Laurent & Charras
"Le Contemporain"
50, Chemin de la Bruyère
69574 Dardilly Cédex (FR)**

(56) Documents cités:
**WO-A-99/52206  US-A1- 2004 266 365**

• **PETER M ASBECK ET AL: "Synergistic Design of
DSP and Power Amplifiers for Wireless
Communications" IEEE TRANSACTIONS ON
MICROWAVE THEORY AND TECHNIQUES, IEEE
SERVICE CENTER, PISCATAWAY, NJ, US, vol.
49, no. 11, 1 novembre 2001 (2001-11-01),
XP011038477 ISSN: 0018-9480**

**Description**

**DOMAINE DE L'INVENTION**

La présente invention concerne le domaine des émetteurs radiofréquence, notamment ceux utilisés dans les terminaux de communication sans fil tels que les téléphones portables par exemple.

L'invention concerne plus particulièrement des émetteurs radiofréquences reconfigurables capables d'émettre dans une large gamme de puissances et selon plusieurs formats d'émission.

**ETAT DE LA TECHNIQUE**

Dans le domaine de la communication radio sans fil, il existe de nombreux formats de communication par ondes dans la bande de fréquences radio, comme par exemple les normes UHF, GSM, EDGE, WCDMA, 3G, etc..., chacune de ces normes étant associée à une bande de fréquences d'émission particulière (on parle par exemple de bande UHF, bande GSM, bande 3G, etc...).

Toutefois, un émetteur radio adapté pour l'émission selon une norme particulière n'est généralement pas adapté pour l'émission selon une autre norme. Par exemple, l'architecture d'un émetteur radio selon la norme GMSK se fonde sur une modulation directe et comprend à cet effet un modulateur analogique suivi d'un amplificateur de puissance. En revanche, les architectures à boucle polaire sont particulièrement bien adaptées pour transmettre des signaux à enveloppe non constante comme par exemple la modulation 8PSK choisie par la norme EDGE. Mais la boucle polaire ne peut transmettre des signaux à large de bande plus large que les signaux EDGE. D'un autre côté, pour les émissions à large bande comme les émissions selon les normes 3G et OFMD, usuellement seule une architecture à modulation directe et un amplificateur linéaire est concevable.

Pour contourner les incompatibilités entre les architectures d'émission radiofréquence, il existe des terminaux équipés de plusieurs émetteurs, chacun dédié à une norme particulière. Le terminal est ainsi encombrant et mal optimisé. En outre, la rapidité de basculement d'un type d'émission à un autre type d'émission est limitée de sorte qu'une utilisation de ce type de terminal à une occupation opportuniste du spectre radio semble difficilement envisageable.

Par ailleurs, les terminaux utilisant une communication par onde dans la bande de fréquences radio comportent un module d'émission qui délivre à une antenne un signal élaboré à partir des signaux de données, généralement numériques.

En termes de performance, ces modules d'émission doivent être analysés par rapport à différents paramètres. Ainsi, dans la mesure où les appareils qu'ils équipent sont fréquemment portables, un critère important concerne leur consommation d'énergie, puisqu'elle a une influence directe sur l'autonomie de l'appareil. Une faible consommation énergétique est donc généralement recherchée.

Pour obtenir une plus grande efficacité spectrale, les signaux sont modulés en phase et en amplitude. Or, les signaux à amplitude non constante, ou à enveloppe variable, imposent généralement des contraintes sur le type d'amplificateur à utiliser. En effet, pour éviter les distorsions, on préfère utiliser des amplificateurs à réponse linéaire pour amplifier les signaux d'amplitude non constante.

Or, les amplificateurs linéaires sont malheureusement moins performants en termes de consommation d'énergie que les amplificateurs à caractéristique non linéaire.

Par ailleurs, compte tenu de la densité d'occupation des systèmes de communication qui partagent la même gamme de fréquence, il est essentiel que les systèmes d'émission ne génèrent que très peu de parasites dans les bandes de fréquences avoisinantes, et mettent en oeuvre un filtrage très sélectif en sortie.

A ce jour, certaines techniques ont été élaborées pour permettre l'utilisation d'amplificateurs non linéaires pour amplifier des signaux d'amplitude non constante. Une technique connue sous le terme anglo-saxon d'"*outphasing*" permet d'aboutir à des résultats satisfaisants. Ainsi, cette technique consiste, à partir d'un signal d'amplitude variable, à générer deux signaux d'amplitude constante, dont le déphasage est variable en fonction de l'amplitude du signal d'origine.

Ces deux signaux à enveloppe constante, générés à partir du signal de base, sont des signaux intermédiaires qui peuvent ainsi être amplifiés par des amplificateurs à caractéristique non linéaire, sans risque d'introduire de distorsions de signal, puisque l'information d'amplitude n'existe plus.

Après amplification, ces deux signaux intermédiaires sont additionnés par un étage de recombinaison. Grâce au déphasage opposé des deux signaux intermédiaires, cette recombinaison permet d'obtenir en sortie et après amplification, un signal dont l'amplitude est variable et identique à celle du signal d'origine.

Cette technique d'"*outphasing*", basée sur les travaux théoriques présentés par CHIREIX dans "High power outphasing modulation", in Proc IRE, volume 23 Novembre 1935, pages 1370 à 1392, a fait l'objet de diverses évolutions dont celle décrite dans le document US 2006/0078067.

A ce jour, les modules d'amplification fonctionnant sur le principe de l'"*outphasing*" mettent en oeuvre des étages de recombinaison des signaux qui emploient des composants passifs tels que des transformateurs, des lignes de transmission de longueur quart d'ondes, ou des coupleurs magnétiques. De tels composants sont par nature relativement encombrants et globalement peu performants, ce qui rend leur emploi inadapté pour les applications dans des terminaux mobiles.

## EXPOSE DE L'INVENTION

Le but de la présente invention est de résoudre les problèmes susmentionnés en proposant un système d'émission radiofréquence peu encombrant qui soit reconfigurable rapidement afin de fonctionner selon plusieurs formats d'émission, qui permette une communication dans une large gamme de puissances et qui soit performant en termes de consommation d'énergie.

A cet effet, l'invention a pour objet un système d'émission radiofréquence comportant :

- ■ des moyens de production d'un signal numérique complexe quantifié sur N bits ;
- ■ des moyens de transformation du signal numérique complexe en deux signaux numériques complexes d'enveloppe identique et constante et déphasés l'un par rapport à l'autre ;
- ■ une voie de traitement numérique associée à chacun des deux signaux numériques complexes à enveloppe constante et comportant au moins des moyens de filtrage du type sigma-delta pour quantifier sur M bits des signaux transitant dans la voie de traitement, M étant inférieur à N ;
- ■ des moyens de conversion numérique/analogique pour convertir les sorties des voies de traitement numérique en des signaux analogiques ;
- ■ moyens de filtrage sélectif de type passe-bande des signaux analogiques dans une bande de fréquences d'émission prédéterminée ;

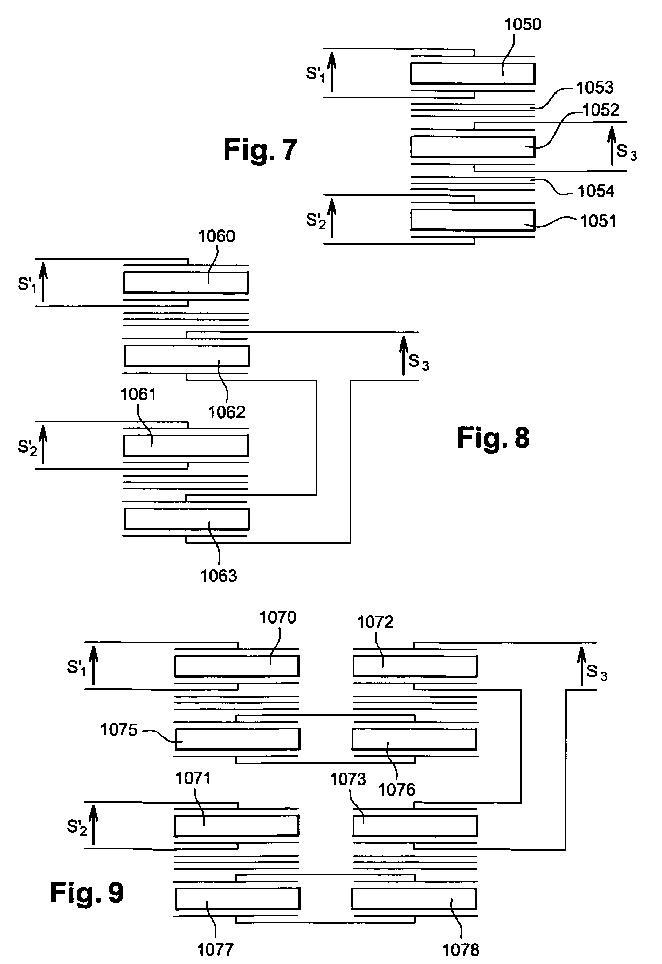

La figure 8 de PETER M ASBECK ET AL: "Synergistic Design of DSP and Power Amplifiers for Wireless Communications", IEEE TRANSACTIONS ON MICROWAVE THEORY AND TECHNIQUES, IEEE SERVICE CENTER, PISCATAWAY, NJ, US, vol. 49, no. 11, 1 novembre 2001.ISSN: 0018-9480 décrit un système d'émission radiofréquence selon le préambule de la revendication 1. Au-delà, la figure 13 du même document ainsi que WO 99/52206 A (ERICSSON INC [US]), 14 octobre 1999, page 29, lignes 18-26, decrivent l'utilisation de convertisseurs élevateurs de fréquence numérques avec modulateurs sigma-delta.

- ■ des moyens d'amplification des signaux analogiques filtrés ; et
- ■ des moyens de recombinaison des signaux analogiques amplifiés.

En d'autres termes, la modulation du signal est réalisée uniquement en numérique. De fait, l'émetteur est reconfigurable à loisir, et cela de manière rapide puisqu'il s'agit uniquement de changer de mode de programmation des signaux.

Toutefois, on notera que pour réaliser une conversion numérique/analogique à une fréquence d'échantillonnage élevée (pouvant aller à plusieurs GHz), il est nécessaire de réduire le nombre de bits de quantification. Dans le cas contraire, l'utilisation de convertisseurs rapides induit une consommation d'énergie importante qui n'est pas compatible avec certaines applications visées, notamment dans les téléphones cellulaires sans fil. En outre, la conversion numérique/analogique à 8 ou 10 bits est encore limitée à quelques dizaines de MHz.

Or, une réduction grossière du nombre de bits de quantification s'accompagne d'une forte erreur de quantification qui s'étale de façon uniforme sur tout le spectre, rendant ainsi le signal de sortie impropre à la communication radiofréquence.

Une réduction du nombre de bits de quantification par l'utilisation d'un filtrage sigma-delta a pour effet de mettre en forme le spectre de puissance du bruit de quantification. Ainsi, les paramètres du filtrage définissent une bande de fréquences sur laquelle le signal de sortie présente un bon rapport signal sur bruit.

Une fois la conversion en analogique effectuée, un filtrage sélectif du signal dans cette bande de fréquences permet d'avoir un bruit très limité hors de cette bande, voire éliminé. Il est ainsi obtenu un signal radiofréquence propre à la communication radiofréquence.

Par ailleurs, afin de produire simplement des signaux de puissance moyenne élevée et sans consommation d'énergie excessive, une transformation des signaux numériques à enveloppe non constante selon la technique du « outphasing » est réalisée. Les signaux ainsi obtenus ont donc une enveloppe constante et sont amplifiés après leur conversion en analogique, de préférence à l'aide d'amplificateur de puissance fonctionnant en mode saturé.

Le système selon l'invention tire ainsi partie de la synergie entre une technique de modulation numérique à hautes fréquences grâce à l'utilisation d'un filtrage sigma-delta combiné à un filtrage passe-bande sélectif et une technique du type « *outphasing* » autorisant la production de signaux à enveloppe non constante de puissance moyenne élevée.

Selon un mode particulier de l'invention, les moyens de production comprennent des moyens de génération d'un signal numérique complexe quantifiés sur N bits et échantillonné à une première fréquence prédéterminée et des moyens de sur-échantillonnage du signal numérique complexe échantillonné à la première fréquence à une seconde fréquence prédéterminée. Notamment, les moyens de sur-échantillonnage réalisent à un sur-échantillonnage par décimation et interpolation.

En d'autres termes, le signal numérique complexe est modulé dans la bande de base puis sur-échantillonné.

Selon un mode de réalisation particulier de l'invention, la voie de traitement numérique comprend en outre:

■ des moyens de sur-échantillonnage par répétition aptes à insérer L-1 zéros entre chaque échantillon d'un signal d'entrée numérique reçu par ceux-ci ; et
■ des moyens de convolution aptes à convoluer des signaux numériques de sortie des moyens de sur-échantillonnage par répétition par une séquence quantifiée sur M bits, de longueur égale à L ou 2L échantillons, et échantillonnée à L fois la seconde fréquence.

En d'autres termes, afin d'augmenter la fréquence radiofréquence d'émission, par exemple au delà de celles auxquelles les moyens de filtrage du type sigma-delta peuvent fonctionner, un sur-échantillonnage par répétition est effectué.

Selon un mode de réalisation particulier de l'invention, les moyens de filtrage du type sigma-delta sont aptes à fonctionner en bande de base.

En d'autre termes, le filtre sigma delta de type passe-bas atténue le bruit de quantification aux basses fréquences et les rejettent au-delà, garantissant un bon rapport signal bruit en bande de base jusqu'à sa fréquence de coupure.

Selon un mode de réalisation particulier de l'invention, les moyens de filtrage du type sigma-delta sont aptes à fonctionner en passe-bande.

En d'autres termes, les moyens de génération du signal produisent un signal numérique non plus complexe (en quadrature) mais réel (seulement une composante), qui est déjà transposé, par exemple par un produit vectoriel, dans la bande de fréquence du modulateur sigma delta passe-bande. Ce modulateur atténue le bruit de quantification dans sa bande de fréquence et le rejette au-delà, garantissant un bon rapport signal bruit dans sa bande passante.

Le mode de réalisation utilisant un filtre sigma-delta de type passe-bas permet de dégager une bande de fréquence plus large que le mode de réalisation utilisant un filtre sigma-delta de type passe-bande.

En revanche, le mode de réalisation basé sur le filtre sigma-delta passe-bande est plus économe, plus simple et n'est pas affecté par les problèmes de fréquence image que rencontre le mode de réalisation basé sur le filtre sigma-delta passe-bas.

Selon un mode de réalisation particulier de l'invention, la voie de traitement numérique comporte des moyens de sélection de canal.

En d'autres termes, à l'aide des moyens de sélection il est possible de choisir un canal de fréquence dans une bande de fréquence dont les moyens de sur-échantillonnage par décimation et interpolation, éventuellement associés aux moyens de sur-échantillonnage par répétition, définissent le canal central. Un degré de flexibilité supplémentaire dans le choix de la fréquence radio d'émission est ainsi obtenu.

Selon un mode de réalisation particulier de l'invention, la voie de traitement numérique comporte des moyens aptes à réaliser un produit vectoriel entre un signal numérique complexe reçu en entrée et un vecteur tournant d'amplitude constante prédéterminée.

En d'autres termes, cette opération de produit vectoriel permet de transposer un signal numérique complexe en bande de base vers un signal numérique complexe à plus haute fréquence, celle-ci étant inférieure ou égale à la moitié de la fréquence d'échantillonnage. Le résultat de ce produit est signal en nombre complexe dont le spectre ne contient que des composantes fréquentielles positives. Le choix de l'amplitude du vecteur tournant permet d'ajuster l'amplitude du signal sortant.

Selon un mode de réalisation particulier de l'invention, la voie de traitement numérique comporte des moyens de sélection de la partie réelle du signal numérique complexe à enveloppe constante.

En d'autres termes, seule la partie réelle du signal est conservée dans les cas ou elle seule présente un intérêt pour la suite du traitement numérique.

Selon un mode de réalisation particulier de l'invention, les moyens de filtrage sélectif du type passe-bande comprennent des filtres BAW-CRF (pour « Bulk Acoustic Wave - Coupled Résonator Filter »).

En d'autres termes, il est utilisé un filtre très sélectif, capable de sélectionner une bande de fréquences de quelques dizaines de Mégahertzs et peu encombrant. La fonction de ce filtre est doublement importante. Il permet d'éliminer le bruit de quantification généré par le filtre sigma-delta et il rend au signal sa propriété d'amplitude constante, propriété qu'il avait perdue après passage dans le filtre sigma delta.

Selon un mode de réalisation particulier de l'invention, les moyens d'amplification comprennent des amplificateurs de puissance fonctionnant en mode saturé ou en compression.

En d'autres termes, les signaux analogiques à enveloppe constante autorisent les amplificateurs à opérer dans leurs zones de saturation, là où le rendement énergétique est élevé et peut atteindre 75%. Une telle amplification permet de consommer moins d'énergie qu'une amplification linéaire.

Selon un mode de réalisation particulier de l'invention, l'impédance de sortie des moyens de conversion numérique/analogique est adaptée à l'impédance d'entrée des moyens de filtrage sélectif.

En d'autres termes, en assurant une adaptation d'impédance de qualité entre la partie numérique et la partie analogique, on peut optimiser la puissance de consommation du circuit numérique.

## BREVE DESCRIPTION DES FIGURES

La présente invention sera mieux comprise à la lecture de la description qui va suivre, donnée uniquement à titre d'exemple, et faite en relation avec les dessins annexés, dans lesquels des références identiques désignent des éléments identiques ou analogues, et dans lesquels :

- la figure 1 est une vue générale d'une architecture d'émission radiofréquence selon l'invention ;
- la figure 2 est une vue schématique d'un premier mode de réalisation de l'architecture de la figure 1 ;
- la figure 3 est une vue schématique d'un deuxième mode de réalisation de l'architecture de la figure 1 ;
- la figure 4 est un spectre de sortie d'un filtre sigma-delta entrant dans la constitution du deuxième mode de réalisation ;
- la figure 5 est une vue schématique plus en détail du module commande des amplificateurs de puissance entrant dans la constitution de l'architecture de la figure 1;
- la figure 6 est un tracé de courbes d'amplification ;
- les figures 7 et 8 sont des vues en coupe schématiques d'un filtre BAW-CRF entrant dans la constitution du circuit de filtrage et de recombinaison du système selon l'invention ;
- la figure 9 est un schéma illustrant une première variante de réalisation de du circuit de filtrage et de recombinaison de la figure 2 ; et
- les figures 10, 11 et 12 sont des vues analogues illustrant d'autres variantes de réalisation.

## DESCRIPTION DETAILLEE DE L'INVENTION

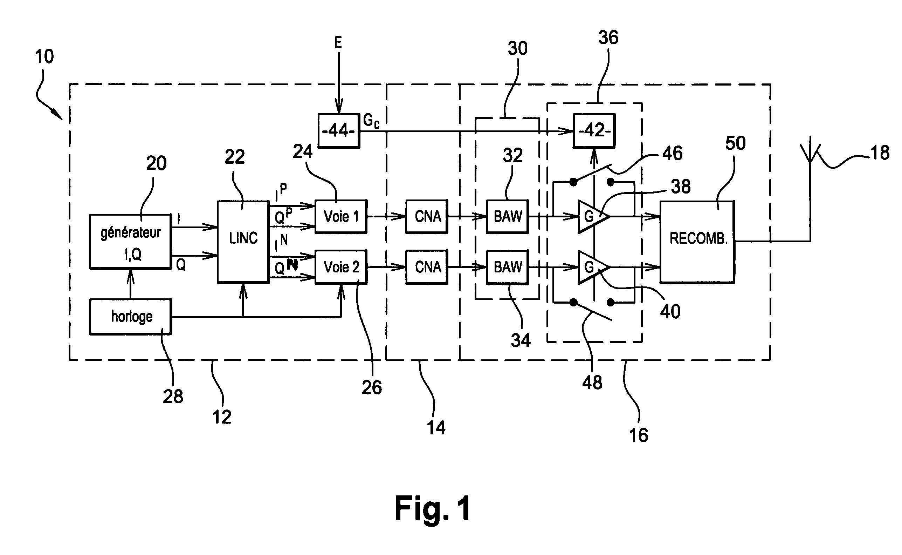

Sur la figure 1, l'architecture générale d'un système d'émission radio fréquence selon l'invention est désignée sous la référence **10.**

Le système **10** selon l'invention comporte un modulateur radiofréquence numérique **12,** un étage de conversion numérique/analogique **14** convertissant des signaux numériques produits par le modulateur **12** en signaux analogiques, un circuit analogique **16** réalisant le filtrage, l'amplification et la recombinaison des signaux délivrés par l'étage de conversion **14,** et une antenne d'émission **18** commandée par le circuit analogique **12.**

Le modulateur radiofréquence numérique **12** comporte un module **20** de production d'un signal numérique complexe S = I + jQ, de partie réelle I et de partie imaginaire Q. Le signal numérique complexe S est échantillonné sur N bits, par exemple six, huit ou dix bits, et selon un format prédéterminé d'émission radiofréquence, comme par exemple la norme GSM, la norme EDGE, la norme WCDMA ou la norme OFDM. Comme cela est connu en soi, le signal numérique complexe S = I +jQ est modulé notamment en amplitude et n'a donc pas une enveloppe constante.

Un module **22** de transformation, connecté au module **20** de production, reçoit le signal numérique complexe S = I + jQ et le transforme en deux signaux numériques complexes $S_{LINC}^{P} = I^{P} + jQ^{P}$ et $S_{LINC}^{N} = I^{N} + jQ^{N}$ d'enveloppe constante identique, et déphasés l'un par rapport à l'autre en mettant en oeuvre de manière numérique la technique dite de « *outphasing* » telle qu'exposée dans le document de CHIREIX précédemment cité.

Selon cette technique, le signal S modulé en amplitude et en phase, s'écrit selon la relation :

$$S(t) = A(t).\exp(j.\omega t + \phi(t))$$

où $j^2 = -1$, t est le temps, A(t) est l'amplitude modulée du signal s, ω est la pulsation de la porteuse du signal s et θ (t) est la phase modulée du signal s.

Le signal S peut se réécrire sous la forme $S(t) = S_{LINC}^{P}(t) + S_{LINC}^{N}(t)$, les signaux $S_{LINC}^{P}$ et $S_{LINC}^{N}$ étant donnés par les relations :

$$S_{LINC}^{P}(t) = A_0 . \exp(j\varphi(t) + j\omega t + j\theta(t))$$

$$S_{LINC}^{N}(t) = A_0 . \exp(-j\varphi(t) + j\omega t + j\theta(t))$$

avec $A_0 = \max\left(\dfrac{A(t)}{2}\right)$ et $\varphi(t) = \cos^{-1}\left(\dfrac{A(t)}{2A_0}\right)$.

Le module **22** génère donc une paire de signaux, $S_{LINC}^{P}$ et $S_{LINC}^{N}$, à enveloppe constante et identique et présentant un déphasage l'un par rapport à l'autre.

Le modulateur radiofréquence numérique **12** comprend également deux voies parallèles de traitement numérique **24, 26,** connectées au module **22** et traitant chacune un signal $S_{LINC}^{P}$ et $S_{LINC}^{N}$. Plus particulièrement, les voies **24, 26** produisent, en fonction des signaux numériques qu'elles reçoivent, des signaux d'enveloppe constante, dont la fréquence d'échantillonnage est élevée à une fréquence radio intermédiaire, et quantifiés sur M bits à l'aide d'un filtrage du type sigma-delta, où M est un nombre de bits inférieur à N.

Le modulateur radiofréquence numérique **12** comporte en outre un générateur d'horloge **28,** qui cadence le fonctionnement des organes venant d'être décrits ainsi que les fréquences d'échantillonnage des signaux transitant dans ceux-ci.

Le circuit analogique de filtrage **16** comprend quant à lui un premier étage de filtrage passe-bande **30**. L'étage **30** comporte des filtres passe-bande **32, 34** très sélectifs, et de préférence des filtres BAW-CRF ci-après décrits plus en détail. Ces filtres **30, 32** atténuent fortement le spectre des signaux délivrés par le modulateur **12** en dehors de la bande d'émission radiofréquence choisie, notamment pour éliminer le bruit de quantification hors de cette bande généré par le filtrage sigma-delta.

Le circuit analogique de filtrage **16** comprend également un étage d'amplification de puissance **36**. L'étage d'amplification **36** comprend deux amplificateurs **38, 40** qui appliquent un gain G aux signaux issus de l'étage de filtrage **30,** les amplificateurs **38, 40** étant de préférence réalisés au moyen de composants non linéaires fonctionnant en mode saturé ou légèrement comprimé.

Le gain G des amplificateurs **38, 40** est réglé par un module de commande de gain **42** recevant une consigne de gain $G_c$ depuis un module de détermination de consigne **44** de préférence intégré au modulateur numérique **12**. Le module **44** détermine la consigne de gain en fonction de la puissance requise pour l'émission par l'antenne, comme cela est par exemple connu de la communication selon la norme GSM dont la puissance du signal émis dépend de la distance du terminal de communication sans fil à la station de base.

L'étage d'amplification **36** comporte optionnellement des commutateurs **46, 48** permettant de court-circuiter les amplificateurs **38, 40** lorsque aucune amplification n'est requise, permettant ainsi dans une telle situation des économies d'énergie.

Enfin, le circuit de filtrage **16** comporte un module de recombinaison **50,** connecté à l'étage d'amplification **36** et reconstituant en fonction des sorties de celui-ci un signal « $s_{ANT}$ » modulé en phase et en amplitude autour de la fréquence d'émission. Le signal $s_{ANT}$ ainsi produit est sensiblement égal, pour la bande de fréquences d'émission choisie, à $s_{ANT}(t) = G.(I^A(t) + jQ^A(t)).\exp(j\omega_{RF}t)$, où $I^A$ et $Q^A$ sont les conversions analogiques des signaux I et Q et $\omega_{RF}$ la pulsation de la porteuse radiofréquence.

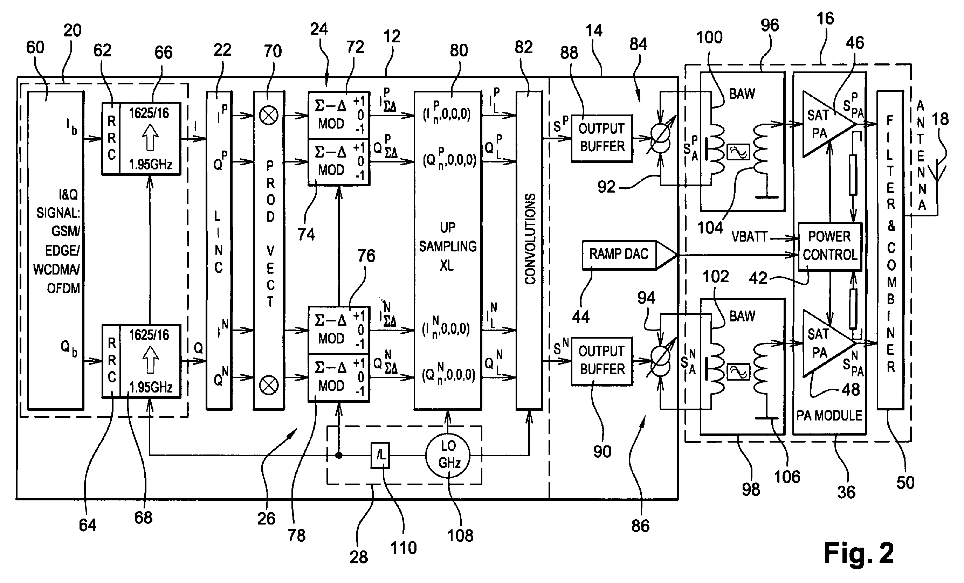

La figure 2 illustre un premier mode de réalisation du système selon l'invention.

Selon ce premier mode de réalisation, le module **20** de production du signal numérique complexe S = I+jQ comporte un générateur de signal numérique **60** qui génère un signal numérique complexe $S_b = I_b + jQ_b$ selon le format d'émission choisi.

Les signaux numériques en quadrature $I_b$ et $Q_b$ sont quantifiés sur N bits, par exemple sur six, huit ou dix bits, et échantillonnés à une fréquence $f_1$ de bande de base. L'information utile des signaux $I_b$ et $Q_b$ occupe donc une bande de fréquences centrée autour de la fréquence zéro.

Le module **20** comporte optionnellement deux filtres RRC (acronyme de l'expression anglo-saxonne « *Root Raised Cosine* ») **62, 64** connectés au générateur **60** et recevant respectivement les signaux $I_b$ et $Q_b$. Les filtres RRC **62, 64** permettent de limiter l'étalement spectral du signal à la largeur du canal envisagé.

Le module **20** comporte en outre des sur-échantillonneurs **66, 68** connectés aux filtres RRC **62, 64** respectivement et produisant les parties réelle et imaginaire I et Q. Chaque sur-échantillonneur **66, 68** élève le signal de sortie du filtre RRC **62, 64** auquel il est connecté à une deuxième fréquence d'échantillonnage $f_2$ par interpolation et décimation. L'information utile des signaux I et Q occupe toujours la même bande de fréquence autour de la fréquence zéro. Un tel sur-échantillonneur est bien connu de l'état de la technique.

Les voies de traitement numérique **24, 26** comprennent chacune un agencement série d'un sélecteur de canal 70, d'une paire de filtres sigma-delta **72, 74, 76, 78**, d'un sur-échantillonneur par répétition 80 et d'un filtre de convolution 82.

Le sélecteur de canal **70** réalise, à la demande, le produit vectoriel de chacun des signaux numériques complexes $S_{LINC}^P = I^P + jQ^P$ et $S_{LINC}^N = I^N + jQ^N$ du module **22** de transformation par un vecteur tournant à une fréquence égale à la différence entre la fréquence du canal d'émission souhaitée $f_{CH}$ et la fréquence du canal central $f_C$. L'information utile est ainsi comprise essentiellement dans une bande de fréquences centrée sur la fréquence ($f_{CH}$ - $f_C$). L'amplitude du vecteur tournant est choisie pour ajuster l'amplitude des signaux en entrée des filtres sigma-delta **72, 74, 76, 78.**

Les filtres sigma-delta **72, 74, 76, 78** sont connectés aux sorties du sélecteur de canal **70**. Chaque filtre sigma-delta quantifie le signal qu'il reçoit sur un nombre inférieur M de bits, par exemple sur 1 ou 1,5 bit, c'est-à-dire sur deux niveaux logiques (0 et 1) ou trois niveaux logiques (-1, 0, 1), tout en mettant en forme le spectre de puissance du bruit de quantification.

Il est ainsi obtenu en sortie des filtres sigma-delta **72, 74, 76, 78** deux signaux complexes numériques quantifiés sur M bits $S_{\Sigma\Delta}^P = I_{\Sigma\Delta}^P + jQ_{\Sigma\Delta}^P$ et $S_{\Sigma\Delta}^N = I_{\Sigma\Delta}^N + jQ_{\Sigma\Delta}^N$.

Les paramètres des filtres sigma-delta **72, 74, 76, 78** sont sélectionnés en fonction du format d'émission choisi et donc de la bande de fréquences correspondant à ce format, de manière à ce que le signal requantifié sur M bits présente un bon rapport signal sur bruit dans cette bande.

De préférence, les paramètres des filtres sigma-delta sont choisis pour que cette bande de fréquences représente en largueur un faible pourcentage de la fréquence d'échantillonnage du signal que le filtre sigma-delta reçoit. Par exemple, pour une émission à la norme WCDMA, le filtre sigma-delta met en forme le spectre du bruit de quantification pour que le rapport signal sur bruit soit bon sur une bande de fréquence de 100 MHz, tandis que le filtre opère avec une fréquence d'échantillonnage de 1.95 GHz. Il en résultera, après sur-échantillonnage par répétition, un bon rapport signal sur bruit dans la bande de 1,90 GHz - 2,00 GHz, qui couvre la bande WCDMA (1,92 GHz - 1,98 GHz).

Les filtres sigma-delta sont classiques et ne seront pas expliqués plus en détail pour des raisons de concision. Pour plus de détails sur l'agencement et le fonctionnement d'un tel filtre, on pourra se reporter par exemple au document « An Overview of sigma delta converters » de PERVEZ M.AZIZ, HENRIK V.SORENSEN & JAN VAN DER SPIEGEL, IEEE signal processing magazine, Janvier 1996.

Le sur-échantillonneur par répétition **80** augmente quant à lui la fréquence d'échantillonnage des signaux numériques $I_{\Sigma\Delta}^P$, $Q_{\Sigma\Delta}^P$, $I_{\Sigma\Delta}^N$, $I_{\Sigma\Delta}^N$ reçus des filtres sigma-delta **72, 74, 76, 78** d'un facteur L prédéterminé.

Le facteur de sur-échantillonnage L est sélectionné en fonction de la bande de fréquences choisie pour l'émission radiofréquence. Le sur-échantilloneur par répétition **80** a la double fonction d'élever la fréquence d'échantillonnage et de répéter L fois le spectre de son signal d'entrée. Ainsi le signal utile contenu en bande de base, se trouvera également répété à la fréquence radio du canal d'émission.

Pour ce faire, entre deux échantillons successifs de signaux numériques $I_{\Sigma\Delta}^P$ sont insérés L-1 zéros. Et de même pour $Q_{\Sigma\Delta}^P$, $I_{\Sigma\Delta}^N$, $I_{\Sigma\Delta}^N$. Par exemple, pour chaque échantillon $I_{\Sigma\Delta}^P(n)$ du signal $I_{\Sigma\Delta}^P$, où n est le n$^{ième}$ instant d'échantillonnage, une séquence $[I_{\Sigma\Delta}^P(n)\ 0\ 0\ 0]$ est produite. Les suites numériques $I_L^P$, $Q_L^P$, $I_L^N$, $I_L^N$ ainsi produites sont donc L fois plus longues et cadencées L fois plus vite que les signaux numériques $I_{\Sigma\Delta}^P$, $Q_{\Sigma\Delta}^P$, $I_{\Sigma\Delta}^N$, $I_{\Sigma\Delta}^N$ reçus par le sur-échantillonneur 80.

Les suites numériques $I_L^P$, $Q_L^P$, $I_L^N$, $I_L^N$ sont alors convoluées par le filtre de convolution **82** avec des séquences de longueur L ou 2L afin d'obtenir deux suites numériques $S^P$ et $S^N$ d'échantillons, par exemple égaux à :

$$S^{P}(n)=[\; Q_{\Sigma\Delta}^{P}(n-1)\quad I_{\Sigma\Delta}^{P}(n)\quad -Q_{\Sigma\Delta}^{P}(n)\quad -I_{\Sigma\Delta}^{P}(n)\;]$$

et,

$$S^{N}(n)=[\; Q_{\Sigma\Delta}^{N}(n)\qquad I_{\Sigma\Delta}^{N}(n)\quad -Q_{\Sigma\Delta}^{N}(n)\quad -I_{\Sigma\Delta}^{N}(n)\;].$$

L'étage de conversion numérique/analogique **14** comporte quant à lui deux convertisseurs numérique/analogique **84, 86** connectés au filtre de convolution **82** pour recevoir les suites numériques $S^{P}$ et $S^{N}$ respectivement.

Chaque convertisseur numérique/analogique **84, 86** comprend un tampon de sortie **88, 90** qui réalise la conversion des signaux numériques en impulsion de courant, ainsi qu'une source de courant **92, 94**.

La source de courant **92, 94** est pilotée par la sortie du tampon **88, 90** et produit une impulsion positive de courant lorsque la sortie du tampon **88, 90** est positive, c'est-à-dire lorsque la valeur correspondante de la suite numérique $S^{P}$ et $S^{N}$ est égale à +1, une impulsion négative de courant lorsque la sortie du tampon **88, 90** est négative c'est-à-dire lorsque la valeur correspondante de la suite numérique $S^{P}$ et $S^{N}$ est égale à -1, et un courant sensiblement nul lorsque la sortie du tampon **88, 90** est sensiblement nulle, c'est-à-dire lorsque la valeur correspondante de la suite numérique $S^{P}$ et $S^{N}$ est nulle.

On notera ainsi que le convertisseur numérique/analogique est très simple, capable de fonctionner à une fréquence très élevée comprise entre 5 et 10 GHz, et produit des impulsions très courtes.

Le circuit analogique de filtrage 16 comprend deux filtres BAW-CRF **96, 98**. Les résonateurs d'entrée **100, 102** de ceux-ci sont connectés respectivement aux sources de courant **92, 94** de l'étage de conversion numérique/analogique **14**. Les bornes des résonateurs de sortie **104, 106** des filtres BAW-CRF sont quant à elles connectés à la masse GND et aux amplificateurs **46, 48** respectivement. Une impulsion de courant circulant dans le résonateur d'entrée d'un filtre BAW-CRF crée alors, aux bornes du résonateur de sortie **104, 106** de celui-ci, une tension positive, négative ou nulle en fonction de la valeur de l'impulsion de courant.

Une tension filtrée de manière sélective, c'est-à-dire dont les composantes spectrales hors de la bande de fréquence d'émission choisie sont atténuées, est ainsi obtenue aux bornes de sortie de chaque filtre BAW-CRF avant son amplification par l'étage d'amplification **36**.

Le module de recombinaison **50** additionne quant à lui les sorties des amplificateurs **46, 48,** le signal de commande $s_{ANT}$ de l'antenne **18** étant ainsi produit.

Enfin le générateur d'horloge **28** du modulateur radiofréquence numérique **12** comprend une horloge pilotable **108** qui fonctionne à la fréquence $L.f_{2}$ et commande la fréquence de fonctionnement du sur-échantillonneur par répétition **80** et du filtre de convolution **82**. Un diviseur de fréquence **110** est par ailleurs prévu. Le diviseur de fréquence **110** divise la fréquence de l'horloge **108** par le facteur L et commande la fréquence de fonctionnement des sur-échantillonneurs par décimation et interpolation **66, 68** et des filtres sigma-delta **72, 74, 76, 78**.

Ainsi la commande de la fréquence de l'horloge 108 et/ou du facteur L permet de régler la fréquence d'émission radio dans un large spectre de fréquences radio.

Comme par ailleurs, le format des données est réglé dans la bande de base par une programmation appropriée du générateur de signal **60,** il n'est donc pas besoin de prévoir des circuits spécifiques pour chaque norme d'émission et sa bande de fréquence associée.

Les filtres sigma-delta **72, 74, 76, 78** peuvent usuellement fonctionner selon plusieurs modes, notamment en bande de base ou en passe-bande.

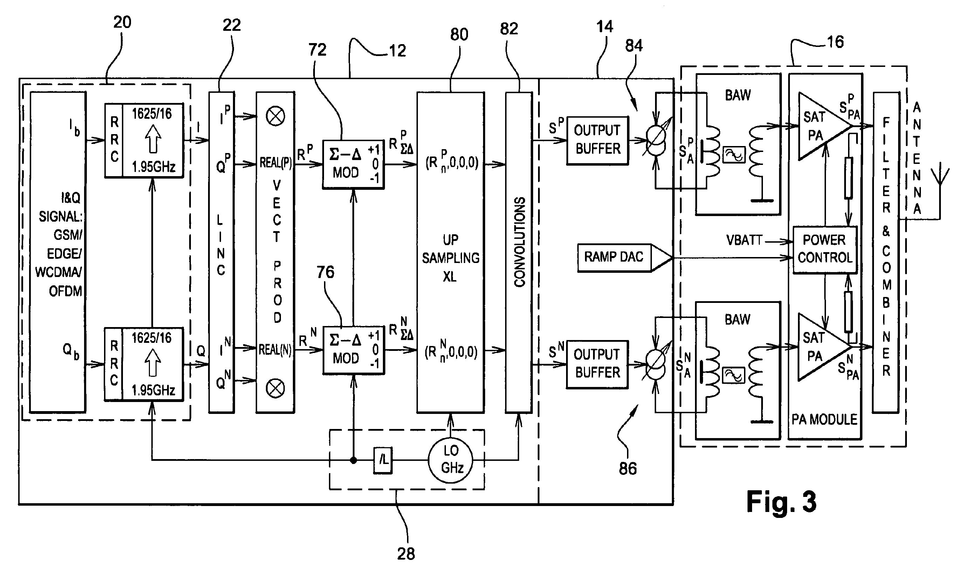

La figure 3 illustre un second mode de réalisation du système selon l'invention.

Ce second mode de réalisation diffère de celui décrit en relation avec la figure 2, en ce que la partie réelle de chaque signal $S_{LINC}^{P}=I^{P}+jQ^{P}$ et $S_{LINC}^{N}=I^{N}+jQ^{N}$ est sélectionnée en sortie du module **22** de transformation, par exemple par le sélectionneur de canal **70** modifié pour mettre en oeuvre cette fonction.

Deux signaux $R^{P}$ et $R^{N}$ étant produit par le sélectionneur de canal **70**, chaque voie de traitement numérique ne comporte alors qu'un seul filtre sigma-delta de type passe-bande **72, 74** fonctionnant en mode passe-bande.

Le sélectionneur de canal **70** réalise, à la demande, le produit vectoriel des parties réelles $I^{P}$ et $I^{N}$ chacun des signaux numériques complexes $S_{LINC}^{P}$ et $S_{LINC}^{N}$ issus du module 22 de transformation par un vecteur tournant d'amplitude programmable dont la fréquence est égale à la différence entre la fréquence du canal d'émission souhaitée $f_{CH}$ et la fréquence du canal central $f_{C}$ à laquelle s'ajoute encore la fréquence centrale $f_{BP}$ du filtre sigma-delta **72, 74**.

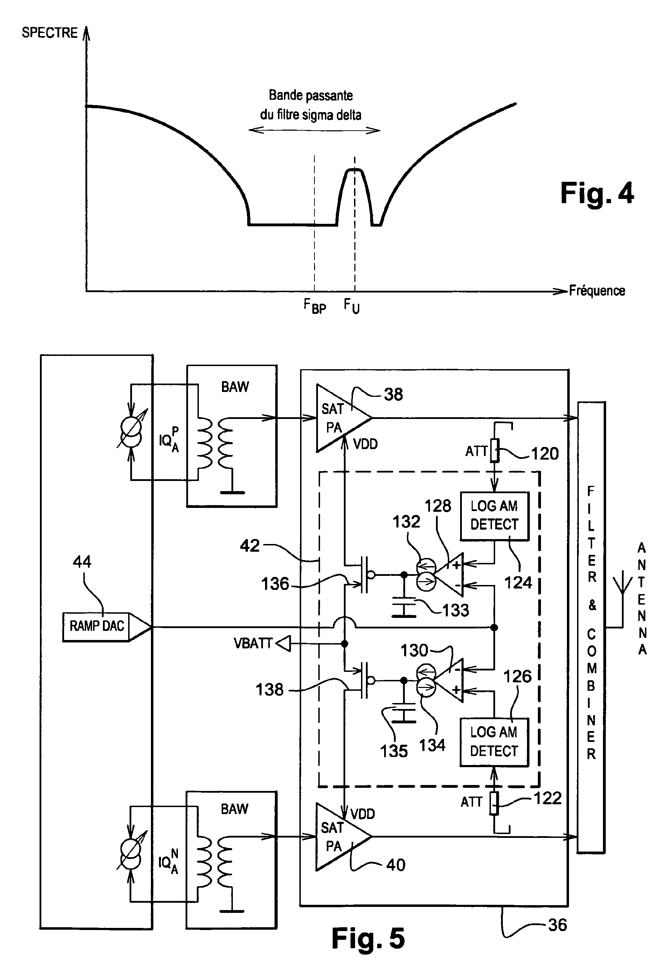

Il est à noter que les fréquences $f_C$ et $f_{BP}$ ne sont pas identiques puisque $f_C$ fait référence à la fréquence du canal central d'émission au niveau de l'antenne, tandis que $f_{BP}$ fait référence à la fréquence centrale du filtre sigma-delta en mode passe-bande. Si $f_C$ est suffisamment basse, alors, on peut éventuellement confondre $f_C$ et $f_{BP}$ . La figure 4 illustre le cas plus général du spectre du signal de sortie du filtre sigma-delta où l'on voit apparaitre $f_U$ et $f_{BP}$, mais pas $f_c$ qui est beaucoup plus élevée en fréquence.

L'information utile est ainsi comprise essentiellement dans une bande de fréquences centrée sur la fréquence $f_U = f_{BP}+(f_{CH} - f_C)$.

Le produit vectoriel permet d'ajuster le niveau d'amplitude des signaux aux entrées des filtres sigma-delta. En effet, $R_P$ et $R_N$ sont respectivement proportionnels aux signaux :

$$R_P = Re\left[(I^P + j.Q^P) * A * e^{j\omega_U t}\right]$$

$$R_N = Re\left[(I^N + j.Q^N) * A * e^{j\omega_U t}\right]$$

Par ailleurs, dans le cas où des fréquences d'émission compatibles avec la fréquence de fonctionnement maximale des filtres sigma-delta sont choisies, typiquement des fréquences inférieures à 2 GHz, le sur-échantillonneur par répétition **80** et le circuit de convolution **82** peuvent être omis, les sorties des filtres sigma-delta **72, 76** étant directement connectées aux convertisseurs numérique/analogique **84, 86**.

La figure 5 est une vue schématique du module de commande de gain **42** de l'étage d'amplification **36**.

Un avantage de convertir les signaux modulés en amplitude en des signaux d'enveloppe constante est de pouvoir réaliser l'amplification en mode saturé ou en compression et ainsi de pouvoir régler le point de saturation en fonction de la puissance du signal à émettre.

De façon générale, la puissance moyenne d'émission d'un terminal mobile, comme un téléphone cellulaire par exemple, est continuellement ajustée en fonction de la position du terminal par rapport à la station de base la plus proche de celui-ci. Afin d'optimiser la puissance émise, la station de base indique au terminal le niveau de puissance auquel il doit émettre. Le terminal doit donc être équipé de moyens lui permettant de commander la puissance moyenne émise.

Le module de commande de gain **42** du système selon l'invention comporte à cet effet, associé à chaque amplificateur **38, 40,** un coupleur directionnel **120, 122** prélevant une partie du signal en sortie de l'amplificateur **38, 40.** Un circuit **124, 126** de mesure de puissance est connecté au coupleur directionnel **120, 122** et mesure la puissance émise par l'amplificateur **38, 40** en fonction du signal prélevé par le coupleur **120, 122,** comme cela est déjà connu en soi.

Un comparateur **128, 130** est par ailleurs connecté à la sortie du circuit de mesure **124, 126** et reçoit du module **44** la consigne de gain pour les amplificateurs **38, 40.** La mesure de la puissance de sortie pour l'amplificateur **38, 40** est ainsi comparée à la consigne de gain délivrée par le module **44.**

La différence entre les deux entrées du comparateur commande une source de courant qui charge ou décharge un condensateur **133, 135** auquel elle est connectée. La tension établie aux bornes du condensateur **133, 135** détermine la tension de grille d'un transistor de puissance PMOS **136, 138** dont la source est connectée à une tension constante VBATT et le drain fournit en courant l'amplificateur **38, 40.**

Lorsque la puissance émise est trop importante, la source de courant **132, 134,** est active dans le sens sortant et vient ainsi charger de façon continue la tension de grille du transistor **136, 138.** Ceci a pour effet de réduire le courant délivré par le transistor à l'amplificateur **38, 40,** et donc de réduire la puissance émise par l'amplificateur jusqu'à ce que les tensions aux bornes du comparateur s'égalisent. Si la puissance émise est trop faible, c'est l'inverse qui se produit. Le système est donc stable.

Le circuit numérique possède un convertisseur numérique/analogique, appelé RAMPDAC, qui est connecté à l'entrée négative du comparateur.

Lorsque le circuit établit une valeur de consigne RAMPDAC plus forte, la différence de potentiel négative aux bornes du comparateur **128, 130** induit une source de courant entrante qui décharge le condensateur. Ceci a pour effet de réduire la tension de grille, d'augmenter le courant délivré par le transistor **136, 138** et d'accroître la puissance émise par l'amplificateur. L'inverse se produit pour une valeur de consigne RAMPDAC plus faible.

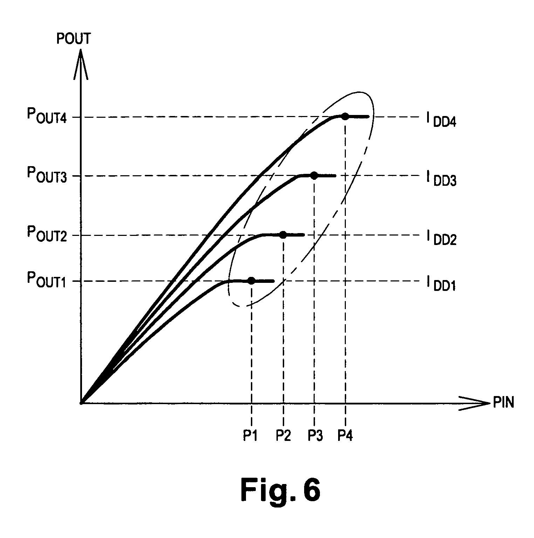

En outre, le module d'amplification de puissance **36** est conçu de sorte que les amplificateurs **38, 40** fonctionnent continuellement en mode saturé. Plus particulièrement, comme cela est illustré à la figure 6, les courbes d'amplification de puissance d'un amplificateur (l'axe des abscisses représentant la puissance du signal en entrée de l'amplificateur et l'axe des ordonnées représentant la puissance du signal en sortie de l'amplificateur) sont paramétrées par le courant $I_{DD}$ alimentant celui-ci.

Un courant $I_{DD}$ plus faible conduit à un point de saturation plus faible et un courant $I_{DD}$ plus élevée conduit à un point de saturation plus élevé.

Les deux variables d'ajustement du système sont la consigne RAMPDAC et la puissance d'entrée du signal. Elles sont calibrées en usine pour que les amplificateurs opèrent toujours dans leur zone de saturation et de manière optimale.

Lorsque le système doit émettre à une puissance élevée, par exemple POUT4, la consigne RAMPDAC et la puissance d'entrée P4 sont ajustées pour que le point de fonctionnement soit positionné sur une caractéristique (POUT, PIN) qui sature pour ce niveau de puissance POUT4.

Lorsque le système doit émettre à une puissance plus faible, par exemple POUT1, la consigne RAMPDAC est réduite et la puissance d'entrée P1 est limitée pour que le point de fonctionnement soit un point de saturation, qui est le point de rendement maximum.

Il va maintenant être décrit plus en détail la structure d'un filtre BAW-CRF en relation avec les figures 7 à 11.

Les filtres BAW-CRF sont constitués par un empilement de plusieurs résonateurs à ondes acoustiques de volume, qui sont couplés par un ensemble de couches acoustiquement passives. Chaque résonateur comporte une couche piézo-électrique, qui est prise en sandwich entre deux électrodes.

De tels filtres fonctionnent de manière simplifiée selon des structures représentées de façon schématique à la figure 7.

Une telle structure de filtre comprend deux résonateurs **1010, 1011.** Chaque résonateur comprend une couche centrale en matériau piézo-électrique **1012** qui est prise en sandwich entre deux électrodes **1013, 1014.** Le second résonateur **1011** comprend une structure analogue avec une couche centrale **1015** prise en sandwich entre deux électrodes **1016,1017.**

Les deux résonateurs **1010, 1011** sont séparés par un ensemble de couches. Cet ensemble de couches **1020** inclut des couches de faible impédance acoustique **1021, 1022** entre lesquelles sont interposées des couches **1023** de haute impédance acoustique.

Dans l'exemple illustré, le nombre de couches représentées est de trois, mais il peut être plus élevé en fonctions des applications. Ces matériaux utilisés sont, de façon classique, des matériaux diélectriques pour les couches de faible impédance acoustique, ou métalliques pour les couches de forte impédance acoustique. Ainsi, un signal électrique appliqué entre les deux électrodes **1013, 1014** du premier résonateur provoque la génération d'un champ acoustique. Ce champ acoustique traverse l'ensemble de couches de couplage **1021-1023** dans la gamme de fréquence définie par les propriétés acoustiques de cet empilement de couches.

Le champ acoustique agissant ainsi sur la couche centrale **1015** du second résonateur provoque la création d'un signal électrique aux bornes des électrodes **1016, 1017** du second résonateur.

Dans une forme de réalisation particulière, illustrée à la figure 8, les deux résonateurs d'entrée **1030** et de sortie **1031** peuvent être couplés non pas directement comme dans le cas de la figure 7, mais par l'intermédiaire d'un ensemble de résonateurs complémentaires **1032, 1033.** Ces résonateurs intermédiaires **1032, 1033** respectivement reçoivent et transmettent les champs acoustiques reçus respectivement depuis le résonateur d'entrée **1030,** et à destination du résonateur de sortie **1031.**

Comme illustré à la figure 9, qui correspond de manière avantageuse au module de recombinaison **50** de la figure 1, deux signaux $s'_1$ et $s'_2$, correspondant par exemple aux tensions analogiques en sortie des amplificateurs **38, 48** du système selon l'invention, sont appliqués respectivement à des résonateurs d'entrée **1050, 1051.** Les champs acoustiques générés par chacun de ces résonateurs d'entrée **1050, 1051** se transmettent au niveau du résonateur de sortie **1052** par l'intermédiaire des empilements de couches acoustiques **1053, 1054.** Dans ce cas, le couplage entre le résonateur d'entrée et le résonateur de sortie est uniquement acoustique. Les champs acoustiques se somment donc au niveau du résonateur de sortie qui délivre un signal de sortie $s_3$ correspondant, aux pertes acoustiques près, à la somme des deux signaux $s'_1$ et $s'_2$.

Dans ce cas de figure, les résonateurs d'entrée **1050** et de sortie **1051,** doivent être réalisés en étant empilés les uns sur les autres dans l'axe de propagation de l'énergie acoustique.

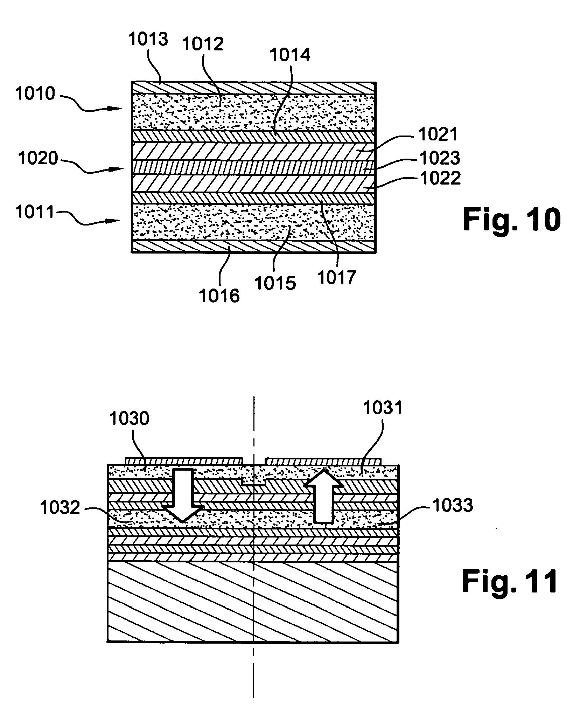

Dans un second mode de réalisation illustrée à la figure 10, les deux résonateurs d'entrée **1060, 1061** sont individuellement reliés à deux résonateurs de sortie **1062, 1063.** Chaque résonateur de sortie **1062, 1063** élabore donc un signal $s_3$ électrique correspondant respectivement aux signaux amplifiés $s'_1$, $s'_2$.

Les résonateurs de sortie **1062, 1063** sont reliés électriquement en série, de telle sorte que le signal de sortie correspond à la somme des tensions générées par chacun des résonateurs de sortie **1062, 1063.** La sommation des deux signaux amplifiés se fait donc par la mise en série des deux résonateurs de sortie.

Dans une forme de réalisation alternative, illustrée à la figure 11, les résonateurs d'entrée **1070, 1071** ne sont pas directement acoustiquement reliés aux résonateurs de sortie **1072, 1073.** En revanche, l'ensemble des résonateurs complémentaires **1075, 1076, 1077, 1078** assurent la transmission du champ acoustique entre les résonateurs d'entrée et les résonateurs de sortie.

Ceci permet comme dans la forme de réalisation illustrée à la figure 8, de réaliser des résonateurs de sortie et d'entrée qui sont situés dans le même plan. La structure de filtrage peut ainsi être considérée comme une structure à deux étages.

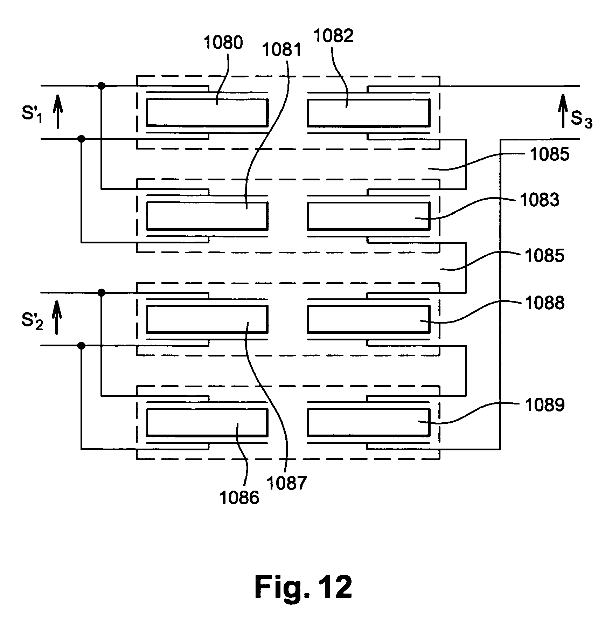

Selon une autre caractéristique de l'invention, il est possible de réaliser une combinaison de filtres BAW-CRF de telle sorte à assurer une adaptation d'impédance à l'impédance de sortie, généralement fixée par l'antenne d'émission. Ainsi, comme illustrée à la figure 12, le signal d'entrée s'$_1$, alimente deux résonateurs d'entrée **1080, 1081,** dont les électrodes sont en parallèle. L'impédance vue au niveau de l'entrée correspond donc à la moitié de l'impédance de chacun des résonateurs.

Ces résonateurs d'entrée **1080, 1081** sont reliés avec des résonateurs de sortie **1082, 1083,** dans la forme illustrée par l'intermédiaire d'un étage de résonateur **1085.** Il en va de même pour le traitement du second signal amplifié qui alimente deux résonateurs d'entrée **1086, 1087,** acoustiquement couplés avec des résonateurs de sortie **1088, 1089.** Les quatre résonateurs de sortie **1082, 1083, 1088, 1089** sont également reliés en série, de telle sorte que l'impédance de sortie correspond sensiblement à quatre fois l'impédance unitaire d'un résonateur de sortie.

Ce montage permet d'assurer une conversion d'impédance entre l'entrée et la sortie de l'étage, en vue de son adaptation à la valeur d'impédance demandée.

Ainsi, on peut atteindre le niveau de puissance requis par les normes d'émission des applications mobiles, en cohérence avec les niveaux de tension de polarisation faible généralement pratiqués sur ce type de structure filtrante.

Bien entendu, des montages plus complexes incluant un nombre de résonateurs différents peuvent être réalisés en fonction des valeurs recherchées.

Par ailleurs, les pertes d'insertion des filtres BAW-CRF sont très réduites, de l'ordre de 2 à 3 décibels, ce qui permet de réduire la dissipation de l'énergie au niveau du circuit de filtrage et de recombinaison.

De plus, grâce à la sélectivité importante des filtres BAW-CRF, il est possible de réduire très fortement la génération de parasites ou du bruit de quantification induit par les filtres sigma-delta du module radiofréquence numérique en dehors de la bande de fréquence d'émission choisie.

En outre, les filtres BAW-CRF venant d'être décrits sont particulièrement avantageux en termes d'encombrement et en termes de coût, puisqu'ils peuvent intégrer des composants montés sur les techniques de flip-chip.

Bien qu'il ait été décrit un système selon l'invention dont le circuit de filtrage et de recombinaison utilise des filtres BAW-CRF, d'autres types de filtres sont envisageables dès lors qu'ils réalisent un filtrage sélectif du bruit de quantification généré par les filtres sigma-delta en dehors de la bande de fréquences d'intérêt.

Par exemple, des filtres SAW à onde acoustique de surface peuvent être utilisés à la place des filtres BAW-CRF **32, 34** en amont de l'étage d'amplification **36.**

Grâce à l'invention, il est ainsi obtenu :

■ une émission radiofréquence de signaux modulés en amplitude dans une large gamme de puissances pouvant atteindre +30 dBm, tout en garantissant une amplification exempte de phénomènes de distorsion d'amplitude et une consommation modérée, par l'utilisation de la technique dite de « *outphasing* » combiné à des amplificateurs fonctionnant en mode saturé ou en compression ;

■ un élargissement du périmètre de fonctionnement d'un modulateur radiofréquence numérique jusqu'aux fréquences radio. Ainsi, par rapport aux circuits analogiques de modulation radiofréquence de l'état de la technique, il est obtenu une plus forte intégration des composants fonctionnels sur une surface réduite, une plus faible consommation énergétique, une reconfigurabilité élevée permettant de basculer rapidement d'un type de communication à un autre, notamment en termes de format de données et de bande de fréquences d'émission, une plus grande insensibilité aux variations de température et de fréquence, une élimination des phénomènes de couplage parasite entre les signaux générés par le système, et un taux de défaillance moindre en raison de l'utilisation de composants fonctionnels numériques en lieu et place de composants fonctionnels analogiques ;

■ une reconfigurabilité, une flexibilité et une rapidité élevée. En effet, les systèmes d'émission multi-standard requièrent une architecture d'émission radio qui s'adapte à son environnement. Par exemple, il peut être souhaité une communication selon la norme WIFI à l'intérieur d'un bâtiment et une communication selon la norme EDGE à l'extérieur. Les systèmes d'émission selon l'invention sont capables de fournir différentes solution à leur utilisateur et de commuter d'un standard de communication à un autre sans cesser la communication. Le système d'émission selon l'invention est ainsi particulièrement adapté à la communication opportuniste dans un environnement de communication dérégulé puisqu'il est capable de se reconfigurer rapidement et ainsi profiter d'opportunités temporelles, géographiques ou spectrales limitées dans le temps ;

■ une réduction du niveau d'interférence hors bande. En effet, grâce à un filtrage très sélectif appliqué par le circuit de filtrage et de recombinaison, le bruit de quantification, les interférences et les signaux parasites, situés hors de la bande de fréquences en cours d'utilisation par un système selon l'invention, sont sensiblement éliminés. Ainsi, la communication dans des bandes de fréquences voisines n'est pas perturbée par le fonctionnement d'un système selon l'invention ;

■ réduction de l'encombrement. En effet, le passage à un modulateur radiofréquence tout numérique (par exemple réalisé en technologie CMOS sous la forme de circuits ASICS ou FPGA) améliore l'intégration du modulateur radiofréquence dans des circuits situés en amont de celui-ci, comme un circuit de bande de base par exemple. De même, le modulateur selon l'invention peut être associé un calculateur dédié au traitement du signal. En outre, les filtres sélectifs BAW-CRF sont d'encombrement réduit en comparaison des filtres SAW de l'état de la technique. Ainsi, l'utilisation des filtres analogiques BAW-CRF n'est pas limitative en termes d'encombrement.

**Revendications**

1. Système d'émission radiofréquence comportant :

   ■ des moyens (20) de production d'un signal numérique complexe quantifié sur N bits ;
   ■ des moyens (22) de transformation du signal numérique complexe en deux signaux numériques complexes d'enveloppe identique et constante et déphasés l'un par rapport à l'autre ;

   caractérisé par:

   ■ une voie (24, 26) de traitement numérique associée à chacun des deux signaux numériques complexes à enveloppe constante et comportant au moins des moyens (72-78) de filtrage du type sigma-delta pour quantifier sur M bits des signaux transitant dans la voie de traitement, M étant inférieur à N ;
   ■ des moyens (14) de conversion numérique/analogique pour convertir les sorties des voies de traitement numérique en des signaux analogiques ;
   ■ moyens (30) de filtrage sélectif de type passe-bande des signaux analogiques dans une bande de fréquences d'émission prédéterminée ;
   ■ des moyens (36) d'amplification des signaux analogiques filtrés ; et
   ■ des moyens (50) de recombinaison des signaux analogiques amplifiés.

2. Système d'émission radiofréquence selon la revendication 1, dans lequel les moyens (20) de production comprennent des moyens (60) de génération d'un signal numérique complexe quantifié sur N bits et échantillonné à une première fréquence prédéterminée et des moyens (66) de sur-échantillonnage du signal numérique complexe échantillonné à la première fréquence à une seconde fréquence prédéterminée.

3. Système d'émission radiofréquence selon la revendication 1 ou 2, dans lequel la voie (24, 26) de traitement numérique comprend en outre :

   ■ des moyens (80) de sur-échantillonnage par répétition aptes à insérer L-1 zéros entre chaque échantillon d'un signal d'entrée numérique reçu par ceux-ci ; et
   ■ des moyens (82) de convolution aptes à convoluer des signaux numériques de sortie des moyens de sur-échantillonnage par répétition par une séquence quantifiée sur M bits, de longueur égale à L ou 2L échantillons, et échantillonnée à L fois la seconde fréquence.

4. Système d'émission radiofréquence selon l'une quelconque des revendications précédentes, dans lequel les moyens (74-78) de filtrage du type sigma-delta sont aptes à fonctionner en bande de base.

5. Système d'émission radiofréquence selon l'une quelconque des revendications 1 à 4, dans lequel les moyens (74-78) de filtrage du type sigma-delta sont aptes à fonctionner en passe-bande.

6. Système d'émission radiofréquence selon l'une quelconque des revendications précédentes, dans lequel la voie (24, 26) de traitement numérique comporte des moyens (70) de sélection de canal.

7. Système d'émission radiofréquence selon l'une quelconque des revendications précédentes, dans lequel la voie de traitement numérique comporte des moyens (70) aptes à réaliser un produit vectoriel entre un signal numérique complexe reçu en entrée et un vecteur tournant d'amplitude constante prédéterminée.

8. Système d'émission radiofréquence selon l'une quelconque des revendications précédentes, dans lequel la voie (24, 26) de traitement numérique comporte des moyens (70) de sélection de la partie réelle du signal numérique complexe à enveloppe constante.

9. Système d'émission radiofréquence selon l'une quelconque des revendications précédentes, dans lequel les moyens (30) de filtrage sélectif du type passe-bande comprennent des filtres BAW-CRF (32, 34).

10. Système d'émission radiofréquence selon l'une quelconque des revendications précédentes, dans lequel les moyens (36) d'amplification comprennent des amplificateurs (38, 40) de puissance fonctionnant en mode saturé ou en compression.

11. Système d'émission radiofréquence selon l'une quelconque des revendications précédentes, dans lequel l'impédance de sortie des moyens (14) de conversion numérique/analogique est adaptée à l'impédance d'entrée des moyens (30) de filtrage sélectif.

**Claims**

1. A radiofrequency transmission system comprising:

   ■ means (20) of producing a complex digital signal quantised on N bits;
   ■ means (22) of transforming the complex digital signal into two complex digital signals with an identical and constant envelope that are phase-shifted with respect to one another;

   **characterized by** :

   ■ a digital processing pathway (24, 26) associated with each of the two complex digital signals with a constant envelope and comprising at least some filtering means (72-78) of the sigma-delta type for quantising on M bits signals travelling in the processing pathway, M being less than N;
   ■ digital-to-analogue conversion means (14) for converting the outputs of the digital processing pathways into analogue signals;
   ■ means of selectively filtering (30) (of the bandpass type) the analogue signals in a predetermined transmission frequency band;
   ■ means (36) of amplifying the filtered analogue signals; and
   ■ means (50) of recombining the amplified analogue signals.

2. The radiofrequency transmission system as claimed in claim 1, wherein the means (20) of producing comprise means (60) of generating a complex digital signal quantised on N bits and sampled at a first predetermined frequency and means (66) of over-sampling the complex digital signal sampled at the first frequency at a second predetermined frequency.

3. The radiofrequency transmission system as claimed in claim 1 or 2, wherein the digital processing pathway (24, 26) also comprises:

   ■ means (80) of repetition over-sampling capable of inserting L-1 zeroes between each sample of a digital input signal received by said means; and
   ■ convolution means (82) capable of convoluting the digital output signals of the repetition over-sampling means with a sequence quantised on M bits having a length equal to L or 2L samples and sampled L times the second frequency.

4. The radiofrequency transmission system as claimed in any of the above claims, wherein sigma-delta type filtering means (74-78) is capable of operating in baseband mode.

5. The radiofrequency transmission system as claimed in any of claims 1 to 4, wherein sigma-delta type filtering means (74-78) is capable of operating in bandpass mode.

6. The radiofrequency transmission system as claimed in any of the above claims, wherein digital processing pathway (24, 26) comprises channel selection means (70).

7. The radiofrequency transmission system as claimed in any of the above claims, wherein the digital processing channel comprises means (70) capable of producing a vector product between a complex digital signal received on an input and a phasor with a predetermined constant amplitude.

8. The radiofrequency transmission system as claimed in any of the above claims, wherein digital processing pathway (24, 26) comprises means (70) of selecting the real part of the complex digital signal with a constant envelope.

9. The radiofrequency transmission system as claimed in any of the above claims wherein the selective filtering means (30) of the bandpass type comprises BAW-CRF filters (32, 34).

10. The radiofrequency transmission system as claimed in any of the above claims, wherein the means of amplification (36) comprises power amplifiers (38, 40) which operate in saturation or compression mode.

11. The radiofrequency transmission system according to any of the above claims, wherein the output impedance of digital-to-analogue conversion means (14) is matched to the input impedance of selective filtering means (30).


**Patentansprüche**

1. Funkfrequenzsendesystem, Folgendes umfassend:

   • Einrichtungen (20) zur Herstellung eines komplexen, auf N Bits quantisierten digitalen Signals;
   • Einrichtungen (22) zum Umwandeln des komplexen digitalen Signals in zwei zueinander phasenverschobene digitale Signale mit gleicher und konstanter Hüllkurve;

   **gekennzeichnet durch**:

   • einen digitalen Verarbeitungskanal (24, 26), der jedem der beiden komplexen digitalen Signale mit konstanter Hüllkurve zugeteilt ist und zumindest Filtereinrichtungen (72 - 78) des Typs Sigma-Delta umfasst, um Signale, die im Verarbeitungskanal durchlaufen, auf M Bits zu quantisieren, wobei M kleiner ist als N;
   • Digital/Analog-Wandlereinrichtungen (14), um die Ausgänge der digitalen Verarbeitungskanäle in analoge Signale umzuwandeln;
   • Einrichtungen (30) des Typs Bandpass zum selektiven Filtern der analogen Signale in einem vorbestimmten Sendefrequenzband;
   • Einrichtungen (36) zum Verstärken der gefilterten analogen Signale; und
   • Einrichtungen (50) zur Rekombination der verstärkten analogen Signale.

2. Funkfrequenzsendesystem nach Anspruch 1, bei dem die Einrichtungen (20) zur Herstellung Einrichtungen (60) zum Erzeugen eines komplexen digitalen Signals, das auf N Bits quantisiert ist und bei einer ersten vorbestimmten Frequenz abgetastet wird, und Einrichtungen (66) zur Überabtastung des bei der ersten Frequenz abgetasteten komplexen digitalen Signals bei einer zweiten vorbestimmten Frequenz umfassen.

3. Funkfrequenzsendesystem nach Anspruch 1 oder 2, bei dem der digitale Verarbeitungskanal (24, 26) darüber hinaus umfasst:

   • Einrichtungen (80) zur Wiederholungsüberabtastung, die L-1 Nullen zwischen jedem Abtastwert eines von diesen empfangenen digitalen Eingangssignals einsetzen können; und
   • Faltungseinrichtungen (82), die digitale Ausgangssignale der Einrichtungen zur Wiederholungsüberabtastung durch eine auf M Bits quantisierte Sequenz falten kann, deren Länge gleich L oder 2L Abstastwerten ist und die beim L-fachen der zweiten Frequenz abgetastet wird.

4. Funkfrequenzsendesystem nach einem der vorhergehenden Ansprüche, bei dem die Filtereinrichtungen (74 - 78) des Typs Sigma-Delta im Basisband arbeiten können.

5. Funkfrequenzsendesystem nach einem der Ansprüche 1 bis 4, bei dem die Filtereinrichtungen (74 - 78) des Typs Sigma-Delta im Bandpass arbeiten können.

6. Funkfrequenzsendesystem nach einem der vorhergehenden Ansprüche, bei dem der digitale Verarbeitungskanal (24, 26) Kanalwahleinrichtungen (70) umfasst.

7. Funkfrequenzsendesystem nach einem der vorhergehenden Ansprüche, in dem der digitale Verarbeitungskanal Einrichtungen (70) umfasst, die ein Vektorprodukt zwischen einem am Eingang empfangenen komplexen digitalen Signal und einem Drehvektor mit vorbestimmter konstanter Amplitude herstellen können.

8. Funkfrequenzsendesystem nach einem der vorhergehenden Ansprüche, bei dem der digitale Verarbeitungskanal (24, 26) Einrichtungen (70) zur Auswahl des Realteils des komplexen digitalen Signals mit konstanter Hüllkurve umfasst

9. Funkfrequenzsendesystem nach einem der vorhergehenden Ansprüche, bei dem die selektiven Filtereinrichtungen (30) des Typs Bandpass BAW-CRF-Filter (32, 34) umfassen.

10. Funkfrequenzsendesystem nach einem der vorhergehenden Ansprüche, bei dem die Verstärkungseinrichtungen (36) Leistungsverstärker (38, 40) umfassen, die im Sättigungs- oder Kompressionsmodus arbeiten.

11. Funkfrequenzsendesystem nach einem der vorhergehenden Ansprüche, bei dem die Ausgangsimpedanz der Digital/ Analog-Wandlereinrichtungen (14) an die Eingangsimpedanz der selektiven Filtereinrichtungen (30) angepasst ist.

**Fig. 1**

Fig. 2

Fig. 3

EP 2 243 268 B1

**Fig. 4**

**Fig. 5**

**Fig. 6**

Fig. 7

1050

$S'_1$

1053

1052

$S_3$

1054

$S'_2$

1051

1060

$S'_1$

1061

1062

$S_3$

$S'_2$

Fig. 8

1063

1070

1072

$S'_1$

$S_3$

1075

1076

1071

1073

$S'_2$

Fig. 9

1077

1078

Fig. 10

Fig. 11

**Fig. 12**

**EP 2 243 268 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20060078067 A

- WO 9952206 A

**Littérature non-brevet citée dans la description**

- High power outphasing modulation. *Proc IRE,* Novembre 1935, (23), 1370-1392
- **PETER M ASBECK et al.** Synergistic Design of DSP and Power Amplifiers for Wireless Communications. *IEEE TRANSACTIONS ON MICROWAVE THEORY AND TECHNIQUES,* 01 Novembre 2001, vol. 49 (11), ISSN 0018-9480

- **DE PERVEZ M.AZIZ ; HENRIK V.SORENSEN ; JAN VAN DER SPIEGEL.** An Overview of sigma delta converters. *IEEE signal processing magazine,* Janvier 1996